**Europäisches Patentamt**

(19) **European Patent Office**

**Office européen des brevets**

(11) Veröffentlichungsnummer: **0 079 514**
**B1**

(12) **EUROPÄISCHE PATENTSCHRIFT**

(45) Veröffentlichungstag der Patentschrift:
23.04.86

(21) Anmeldenummer: **82110074.0**

(22) Anmeldetag: **02.11.82**

(51) Int. Cl.⁴: **G 03 C 1/68**

(54) Zur Herstellung von Druck- und Reliefformen geeignetes lichtempfindliches Aufzeichnungsmaterial und Verfahren zur Herstellung von Druck- und Reliefformen mittels dieses Aufzeichnungsmaterials.

(30) Priorität: **12.11.81 DE 3144905**

(43) Veröffentlichungstag der Anmeldung:
**25.05.83 Patentblatt 83/21**

(45) Bekanntmachung des Hinweises auf die Patenterteilung:
**23.04.86 Patentblatt 86/17**

(84) Benannte Vertragsstaaten:
**BE DE FR GB**

(56) Entgegenhaltungen:
**EP - A - 0 038 477**
**CH - A - 499 793**
**DE - A - 1 522 359**

(73) Patentinhaber: **BASF Aktiengesellschaft,
Carl-Bosch-Strasse 38, D-6700 Ludwigshafen (DE)**

(72) Erfinder: **Lynch, John, Dr., Bachusstrasse 15,
D-6521 Monsheim (DE)**
Erfinder: **Naarmann, Herbert, Dr., Haardtblick 15,
D-6719 Wattenheim (DE)**
Erfinder: **Schulz, Guenther, Dr., Wasgaustrasse 24,
D-6700 Ludwigshafen (DE)**
Erfinder: **Vyvial, Rudolf, Alwin-Mittasch-Platz 10,
D-6700 Ludwigshafen (DE)**
Erfinder: **Wallbillich, Guenter, Dr., Eichendorffallee 15,
D-6707 Schifferstadt (DE)**
Erfinder: **Zuerger, Manfred, Holderlandstrasse 2,
D-6920 Sinsheim (DE)**

## Beschreibung

Die Erfindung betrifft ein lichtempfindliches Aufzeichnungsmaterial mit einer auf einer dimensionsstabilen Trägerschicht T haftfest aufgebrachten wasserentwickelbaren, photopolymerisierbaren, reliefbildenden Schicht R, bei dem die reliefbildende Schicht R neben einer photopolymerisierbaren, ethylenisch ungesättigten niedermolekularen Verbindung, einem Photopolymerisationsinitiator sowie gegebenenfalls sonstigen üblichen Zusatzstoffen als Bindemittel einen modifizierten Polyvinylalkohol mit radikalisch polymerisierbaren Gruppen enthält. Die Erfindung betrifft des weiteren ein Verfahren zur Herstellung von Druck- und Reliefformen mittels dieses lichtempfindlichen Aufzeichnungsmaterials.

Lichtempfindliche Aufzeichnungsmaterialien auf der Basis von wasserauswaschbaren Polymeren und Monomeren für die Herstellung von Druck- und Reliefformen sind an sich bekannt (vgl. z.B. die GB-A 834 337, 1 233 883 und 1 351 475 sowie die US-A 4 042 386 und 4 272 611). Gemäss diesen Druckschriften soll als polymeres Bindemittel in der photopolymerisierbaren reliefbildenden Schicht Polyvinylalkohol eingesetzt werden. Die aus diesen bekannten lichtempfindlichen Aufzeichnungsmaterialien hergestellten Druck- und Reliefformen lassen jedoch bezüglich ihrer Herstellung, Lagerung, Wiederverwendbarkeit und Wasserbeständigkeit noch einige Wünsche offen.

Es ist weiterhin beispielsweise aus der US-A 2 929 710, der GB-A 834 337 oder der DE-A 1 522 359 bekannt, in photopolymerisierbaren Mischungen für reliefbildende Schichten von lichtempfindlichen Aufzeichnungsmaterialien als polymeres Bindemittel Derivate von Polyvinylalkohol einzusetzen, die seitenständige photopolymerisierbare Doppelbindungen enthalten. Bei diesen polymerisierbaren Gruppen enthaltenden Derivaten des Polyvinylalkohols handelt es sich beispielsweise um ungesättigte Polyacetale oder ungesättigte Polyester des Polyvinylalkohols. Bezüglich der Herstellung dieser Polyvinylalkohol-Derivate wird in diesen Druckschriften auf die bekannten und üblichen Herstellmethoden verwiesen, gemäss denen die Acetalisierung bzw. Acylierung des Polyvinylalkohols in Lösung durchgeführt wird. Die so hergestellten Polyvinylalkohol-Derivate eignen sich jedoch wegen des relativ grossen Anteils an Verunreinigungen nur sehr beschränkt für den Einsatz in reliefbildenden Schichten von photopolymerisierbaren Aufzeichnungsmaterialien. Um zu qualitativ hochwertigen Produkten zu kommen, müssen die so hergestellten Polyvinylalkohol-Derivate in aufwendiger und kostspieliger Weise gereinigt werden.

Der vorliegenden Erfindung lag die Aufgabe zugrunde, lichtempfindliche Aufzeichnungsmaterialien für die Herstellung von Druck- und Reliefformen aufzuzeigen, die in einfacher und reproduzierbarer Weise hergestellt werden können, wasserentwickelbar sind und dennoch eine hohe Beständigkeit gegenüber Wasser und Feuchtigkeit nach der Belichtung besitzen.

Es wurde nun gefunden, dass diese Aufgabe gelöst wird, wenn in den an sich bekannten wasserentwickelbaren lichtempfindlichen Aufzeichnungsmaterialien in der photopolymerisierbaren reliefbildenden Schicht als polymeres Bindemittel ein Polyvinylalkohol-Derivat enthalten ist, welches 1 bis 30 Gew.%, bezogen auf das Polyvinylalkohol-Derivat, an radikalisch polymerisierbare Gruppen enthaltenden Acylresten eingebaut enthält und hergestellt worden ist durch Umsetzung von Polyvinylalkohol mit polymerisierbare Gruppen enthaltenden Acylierungsmitteln in heterogener Phase in einem aprotischen Dispergiermittel mit einem 2- bis 5-molar-fachen Überschuss an Acylierungsmittel, bezogen auf den Gehalt an Acylgruppen in dem Polyvinylalkohol-Derivat.

Gegenstand der Erfindung ist demzufolge ein zur Herstellung von Druck- und Reliefformen geeignetes lichtempfindliches Aufzeichnungsmaterial mit

(a) einer dimensionsstabilen/Trägerschicht T und

(b) einer damit direkt oder indirekt haftfest verbundenen photopolymerisierbaren, wasserentwickelbaren reliefbildenden Schicht R mit einer Dicke von 300 μm bis 7 mm aus einer Mischung von

(b1) einem ein polymerisierbares Polyvinylalkohol-Derivat enthaltenden polymeren Bindemittel,

(b2) mindestens einer mit dem polymeren Bindemittel verträglichen, ethylenisch ungesättigten, photopolymerisierbaren niedermolekularen Verbindung,

(b3) mindestens einem Photopolymerisationsinitiator sowie gegebenenfalls

(b4) weiteren üblichen Zusatzstoffen, welches dadurch gekennzeichnet ist, dass die reliefbildende Schicht R als polymeres Bindemittel mindestens 1 Gew.%, bezogen auf das gesamte polymere Bindemittel (b1), eines Polyvinylalkohol-Derivats enthält, welches 1 bis 30 Gew.%, bezogen auf das Polyvinylalkohol-Derivat, an radikalisch polymerisierbare Gruppen enthaltenden Acylresten eingebaut enthält und erhalten worden ist durch Umsetzung von Polyvinylalkohol mit einem radikalisch polymerisierbare Gruppen enthaltenden Acylierungsmittel in heterogener Phase in einem aprotischen Dispergiermittel mit einem 2- bis 5-molar-fachen Überschuss an Acylierungsmittel, bezogen auf den Gehalt an Acylgruppen in dem Polyvinylalkohol-Derivat.

Gegenstand der Erfindung sind weiterhin spezielle Ausgestaltungsformen dieses lichtempfindlichen Aufzeichnungsmaterials gemäss der nachfolgenden detaillierten Beschreibung. Gegenstand der Erfindung ist ferner ein Verfahren zur Herstellung von Druck- oder Reliefformen mittels dieses lichtempfindlichen Aufzeichnungsmaterials.

Auch wenn aus der DE-A 3 015 419 die Verwendung von ähnlichen Polyvinylalkohol-Derivaten in härtbaren Mischungen für Haftschichten von lichtempfindlichen Mehrschichtenelementen bekannt war, bringt die erfindungsgemässe Anwendung der genannten, in heterogener Phase hergestellten Polyvinylalkohol-Derivate in der reliefbildenden Schicht R von lichtempfindlichen Aufzeichnungsmaterialien eine Reihe von zum Teil unerwarteten Vorteilen mit sich. So erhält man erfindungsgemäss in einfacher Weise für die Herstellung von Druck- und Reliefformen geeignete, wasserentwickelbare lichtempfindliche Aufzeichnungsmaterialien mit guten, leicht und genau reproduzierbaren Eigenschaften trotz chargenweiser Herstellung der Polyvinylalkoholbindemittel in heterogener Phase. Das Auswaschen der belichteten Aufzeichnungsmaterialien, d.h. das Entfernen der unbelichteten Bestandteile der Reliefschicht mit Wasser, ist problemloser als bei den bisher gebräuchlichen Aufzeichnungsmaterialien auf Basis von Polyvinylalkohol, und man erhält gleichzeitig Druck- und Reliefformen mit besserer Oberfläche. Wegen ihrer sehr hohen Wasserbeständigkeit sind die aus den erfindungsgemässen Aufzeichnungsmaterialien hergestellten Druck- und Reliefformen auch im feuchten Klima sehr lagerstabil und jederzeit wiederverwendbar.

Als dimensionsstabile Trägerschichten T (permanenter Träger) für die photopolymerisierbare reliefbildende Schicht R der erfindungsgemässen Aufzeichnungsmaterialien kommen die für die Herstellung von Druck- und Reliefformen bekannten Träger in Betracht. Hierzu gehören insbesondere dimensionsstabile Kunststoffolien, wie z.B. Polyesterfolien, sowie metallische Träger, z.B. Stahlbleche, Eisenbleche oder Aluminiumbleche. Die dimensionsstabile Trägerschicht T kann in an sich bekannter Weise zur Verbesserung der Haftung mit der photopolymerisierbaren reliefbildenden Schicht R mechanisch, chemisch und/oder durch Versehen mit einer Haftgrundierung vorbehandelt sein.

Die photopolymerisierbare reliefbildende Schicht R der lichtempfindlichen Aufzeichnungsmaterialien soll als Bindemittel erfindungsgemäss mindestens ein Gewichtsprozent, bezogen auf das gesamte Bindemittel der photopolymerisierbaren reliefbildenden Schicht R, des genannten, in heterogener Phase hergestellten Polyvinylalkohol-Derivats enthalten.

Unter Polyvinylalkohol werden dabei im Rahmen dieser Erfindung ganz allgemein Polymere mit wiederkehrenden $CH_2CH(OH)$-Struktureinheiten in der Polymerhauptkette verstanden, soweit diese Polymere in Wasser löslich oder zumindest dispergierbar sind. Diesbezüglich sei auch auf den entsprechenden zitierten Stand der Technik verwiesen. Insbesondere kommen als Polyvinylalkohol die bekannten, teilverseiften Polyvinylester, wie Polyvinylacetate oder Polyvinylpropionate, in Betracht.

Für die Herstellung der erfindungsgemäss einzusetzenden Polyvinylalkohol-Derivate geht man im allgemeinen von Polyvinylalkoholen mit einem mittleren Polymerisationsgrad im Bereich von 350 bis 2500 aus. Der Verseifungsgrad des für die Umsetzung eingesetzten Polyvinylalkohols wird einerseits durch die Bedingung der Wasserlöslichkeit bzw. Wasserdispergierbarkeit und andererseits durch die Höhe des Umsetzungs- bzw. Acylierungsgrades im Endprodukt der Umsetzung, dem Polyvinylalkohol-Derivat, bestimmt. Je höher der Umsetzungs- bzw. Acylierungsgrad mit dem Acylierungsmittel sein soll, desto höher wird im allgemeinen der Verseifungsgrad des für die Umsetzung eingesetzten Polyvinylalkohols liegen. Üblicherweise haben die für die Herstellung der erfindungsgemäss einzusetzenden Polyvinylalkohol-Derivate verwendeten Polyvinylalkohole einen Verseifungsgrad von 80 bis 98 Mol.% und insbesondere 80 bis 88 Mol.%. Es können auch Gemische von Polyvinylalkoholen mit unterschiedlichem Polymerisationsgrad und/oder Verseifungsgrad eingesetzt werden.

Zur Herstellung der erfindungsgemäss einzusetzenden Polyvinylalkohol-Derivate wird der Polyvinylalkohol mit Acylierungsmitteln umgesetzt, die radikalisch polymerisierbare Gruppen eingebaut enthalten. Als Acylierungsmittel kommen dabei die üblichen, für Acylierungsreaktionen gebräuchlichen Verbindungsklassen in Betracht, wie beispielsweise Ester, Säurehalogenide sowie insbesondere Carbonsäureanhydride. Bei den radikalisch polymerisierbaren Gruppen, die in den Acylierungsmitteln enthalten sind, handelt es sich überlicherweise um polymerisierbare ethylenische Doppelbindungen, die vorzugsweise aktiviert sind, d.h. in Konjugation zu anderen Doppelbindungen oder in Nachbarschaft zu Sauerstoff- oder Stickstoffatomen stehen. Besonders vorteilhaft sind daher z.B. die Acylierungsmittel, die sich von Acrylsäure oder Methacrylsäure ableiten, wobei als Acylierungsmittel insbesondere Acrylsäureanhydrid und Methacrylsäureanhydrid hervorzuheben sind.

Die Umsetzung des Polyvinylalkohols mit dem Acylierungsmittel findet erfindungsgemäss in heterogener Phase statt, indem man den Polyvinylalkohol in einem aprotischen Dispergiermittel aufschlämmt und in dieser Aufschlämmung unter gleichzeitiger kräftiger Durchmischung mit dem Acylierungsmittel umsetzt. Für den erfindungsgemässen Einsatz in der reliefbildenden Schicht R der lichtempfindlichen Aufzeichnungsmaterialien wird der Umsatz zwischen dem Polyvinylalkohol und dem Acylierungsmittel in heterogener Phase soweit geführt, dass das erhaltene Polyvinylalkohol-Derivat 1 bis 30 Gew.%, vorzugsweise 2 bis 25 Gew.%, bezogen auf das Polyvinylalkohol-Derivat, an radikalisch polymerisierbaren Acyl-Gruppen eingebaut enthält bzw. einen Acylierungsgrad von 1 bis 30 Gew.% besitzt.

Als aprotische Dispergiermittel kommen insbesondere niedere halogenierte Kohlenwasserstoffe, niedere aliphatische Ketone und aromatische und/oder aliphatische Kohlenwasserstoff-Lösungsmittel in Betracht. Vorzugsweise wird für die Umsetzung Methylenchlorid oder Aceton als Dispergiermittel verwendet. Es hat sich als zweckmässig erwiesen, solche Mengen an aprotischen Dispergiermitteln einzusetzen, dass in der Aufschlämmung aus Polyvinylalkohol und Dispergiermittel 30 bis 75 Gew.%, insbesondere 40 bis 65 Gew.% des Dispergiermittels, bezogen auf die Summe von Polyvinylalkohol und Dispergiermittel, enthalten sind. Um zu Polyvinylalkohol-Derivaten mit einem Gehalt von, bezogen auf das Polyvinylalkohol-Derivat, 1 bis 30 Gew.% an radikalisch polymerisierbare Gruppen enthaltenden Acylresten zu gelangen, die für den erfindungsgemässen Einsatz in den lichtempfindlichen Aufzeichnungsmaterialien geeignet sind, hat es sich als notwendig herausgestellt, dass das Acylierungsmittel bei der Umsetzung mit dem Polyvinylalkohol in einem solchen Überschuss eingesetzt wird, der mindestens dem 2-molarfachen des Acylierungsgrades entspricht, wobei unter Acylierungsgrad der Gehalt des aus der Umsetzung resultierenden Polyvinylalkohol-Derivates an radikalisch polymerisierbare Gruppen enthaltenden Acylresten von, bezogen auf das Polyvinylalkohol-Derivat, 1 bis 30 Gew.% zu verstehen ist. Es hat sich gezeigt, dass das Umsetzungsprodukt um so vorteilhaftere Eigenschaften aufweist, je höher der Überschuss an Acylierungsmittel ist. Die obere Grenze für die Menge an eingesetztem Acylierungsmittel wird allein aus wirtschaftlichen Überlegungen heraus bestimmt, wobei sich ein ca. 5-molarfacher Überschuss, bezogen auf den vorstehend definierten Acylierungsgrad, an Acylierungsmittel im allgemeinen als sinnvolle obere Grenze herausgestellt hat.

Der vorstehend definierte Acylierungsgrad des Polyvinylalkohols wird – ausser durch die Konzentration des Acylierungsmittels – insbesondere durch die Korngrösse des eingesetzten Polyvinylalkohols, die Reaktionstemperatur sowie die Reaktionszeit bestimmt. Polyvinylalkohole mit Teilchengrössen im Bereich von 1 bis 5000 μm haben sich für die Umsetzung mit dem Acylierungsmittel in der heterogenen Phase als geeignet erwiesen, wobei Polyvinylalkohole mit einer mittleren Teilchengrösse von etwa 50 bis 500 μm bevorzugt sind.

Die Reaktionstemperatur für die Acylierung, die beispielsweise über den Siedepunkt des aprotischen Dispergiermittels eingestellt werden kann, liegt im allgemeinen im Bereich von 0 bis 100°C und wird vorzugsweise auf 40 bis 60°C gehalten. Die Reaktionszeit, die sich nach dem gewünschten Acylierungsgrad richtet, beträgt üblicherweise 1 bis 80 Stunden und insbesondere 20 bis 40 Stunden.

Das polymere Bindemittel (b1) der photopolymerisierbaren reliefbildenden Schicht R der lichtempfindlichen Aufzeichnungsmaterialien kann vollständig (zu 100%) oder auch nur teilweise aus dem die polymerisierbaren Acylgruppen enthaltenden Polyvinylalkohol-Derivat bestehen; zumindest soll der Anteil dieses Polyvinylalkohol-Derivats in der polymeren Bindemittel-Komponente (b1) 1 Gew.% betragen. Für die Herstellung von Druck- und Reliefformen sind solche Aufzeichnungsmaterialien besonders geeignet, bei denen das polymere Bindemittel (b1) der photopolymerisierbaren reliefbildenden Schicht R zu 10 bis 40 Gew.%, bezogen auf das gesamte polymere Bindemittel (b1), aus dem die polymerisierbaren Acyl-Gruppen enthaltenden Polyvinylalkohol-Derivat und zu 90 bis 60 Gew.%, bezogen auf das gesamte polymere Bindemittel (b1), aus anderen Polymerbindemitteln besteht. Diese anderen Polymerbindemittel müssen dabei ebenfalls wasserauswaschbar, d.h. wasserlöslich oder zumindest wasserdispergierbar sein und sollen mit dem erwähnten Polyvinylalkohol-Derivat weitgehend verträglich sein. Weitgehend verträglich bedeutet dabei, dass man aus den Komponenten eine homogene Mischung herstellen kann, die für den Einsatz in lichtempfindlichen Aufzeichnungsmaterialien geeignet ist. Als solche anderen Polymerbindemittel kommen beispielsweise in Betracht: nichtmodifizierte Polyvinylalkohole als solche; andere Polyvinylalkohol-Derivate, wie z.B. oxethylierter Polyvinylalkohol wie er z.B. in der US-A 4 272 611 für den Einsatz in photopolymerisierbaren Mischungen beschrieben ist; Polyvinylpyrrolidon und N-Vinylpyrrolidon-Copolymerisate, z.B. N-Vinylpyrrolidon/Vinylacetat-Copolymerisate; Zellulosederivate, Stärke und/oder Stärke-Derivate; Acrylsäure-Copolymerisate oder Polyvinylcinnamate.

Als photopolymerisierbare, ethylenisch ungesättigte niedermolekulare Verbindungen (b2) kommen die an sich bekannten Monomeren und/oder Oligomeren (mit einem Molekulargewicht bis zu 5000, vorzugsweise mit einem Molekulargewicht bis zu 3000) in Frage, die für lichtempfindliche Aufzeichnungsmaterialien der in Rede stehenden Art üblich und gebräuchlich und beispielsweise in der eingangs zitierten Literatur beschrieben sind. Die Photopolymerisierbaren niedermolekularen Verbindungen können dabei eine oder mehrere ethylenisch ungesättigte Doppelbindungen enthalten, wobei bevorzugt ist, dass zumindest ein Teil, vorzugsweise etwa 1 bis 40 Gew.%, der photopolymerisierbaren niedermolekularen Verbindungen mehr als eine ethylenisch ungesättigte Doppelbindung enthält. Da in den erfindungsgemässen lichtempfindlichen Aufzeichnungsmaterialien das polymere Bindemittel der reliefbildenden Schicht R ebenfalls photopolymerisierbare Gruppen enthält, ist es ebenso möglich, dass in der photopolymerisierbaren reliefbildenden Schicht R ausschliesslich photopolymerisierbare niedermolekulare Verbindungen mit nur einer ethylenischen Doppelbindung eingesetzt werden, wenn der Anteil des die polymerisierbaren Acylgruppen enthaltenden Polyvinylalkohol-Derivats in der Bindemittel-Komponente (b1) und/oder der Acylierungsgrad dieses Polyvinylalkohol-Derivats entsprechend eingestellt wird. Die Auswahl von Art und Menge der photopolymerisierbaren, ethylenisch ungesättigten niedermolekularen Verbindungen wird einerseits von dem beabsichtigten Verwendungszweck der lichtempfindlichen Aufzeichnungsmaterialien, z.B. der gewünschten Härte der daraus gebildeten Reliefformen bestimmt, andererseits von der Verträglichkeit der Monomeren mit den eingesetzten polymeren Bindemitteln in der photopolymerisierbaren reliefbildenden Schicht R sowie der Forderung, dass die photopolymerisierbare reliefbildende Schicht R in Wasser auswaschbar, d.h. löslich oder dispergierbar sein soll. Üblicherweise besitzen die photopolymerisierbaren ethylenisch ungesättigten niedermolekularen Verbindungen einen Siedepunkt bei Normaldruck von über 100°C.

Als Beispiele bevorzugter photopolymerisierbarer ethylenisch ungesättigter niedermolekularer Verbindungen seien solche mit Hydroxylgruppen, Amidgruppen und Polyethylenglykol-Struktureinheiten genannt. Sehr geeignet sind Mono- und Polyacrylate und/oder -methacrylate von ein- und mehrwertigen niedermolekularen Alkoholen, z.B. Hydroxyalkyl(meth)acrylate mit 1 bis 8 Kohlenstoffatomen im Alkylrest, wie z.B. β-Hydroxyethylacrylat, β-Hydroxypropylacrylat, β-Hydroxyethylmethacrylat, Ethylenglykoldi(meth)acrylat, Mono- und Di-(meth)acrylate von Polyethylenglykolen oder Polypropylenglykolen mit Molekulargewichten bis ca. 500, Butandiol-1,4-di(meth)acrylat, 1,1,1-Trimethylolpropan-tri(meth)acrylat oder Glycerin-di- oder -tri-(meth)acrylat. Geeignet sind ferner niedermolekulare, präpolymere Urethanacrylate, wie sie z.B. durch Umsetzung von Hydroxyalkyl-(meth)acrylaten [z.B. β-Hydroxyethyl-(meth)acrylat, β-Hydroxypropyl-(meth)acrylat], organischen Diisocyanaten (z.B. Hexamethylendiisocyanat, Toluylendiisocyanat oder Isophorondiisocyanat) sowie gegebenenfalls niedermolekularen aliphatischen Diolen als Kettenverlängerern hergestellt werden können.

Das Mengenverhältnis von polymerem Bindemittel (b1) zu den photopolymerisierbaren ethylenisch ungesättigten niedermolekularen Verbindungen (b2) in der photopolymerisierbaren reliefbildenden Schicht R ist in weitem Umfang variierbar und beträgt im allgemeinen etwa 10 bis 90 Gew.% an polymerem Bindemittel (b1) zu 90 bis 10 Gew.% an photopolymerisierbaren, ethylenisch ungesättigten niedermolekularen Verbindungen (b2). Vorzugsweise enthält die photopolymerisierbare reliefbildende Schicht R 40 bis 70 Gew.% an polymerem Bindemittel (b1) und 30 bis 60 Gew.% an photopolymerisierbaren, ethylenisch ungesättigten niedermolekularen Verbindungen (b2), jeweils bezogen auf die Summe von polymerem Bindemittel (b1) und photopolymerisierbaren, ethylenisch ungesättigten niedermolekularen Verbindungen (b2).

Die photopolymerisierbare reliefbildende Schicht R enthält ferner in an sich üblichen Mengen von 0,001 bis 10 Gew.%, vorzugsweise von 0,1 bis 5 Gew.%, bezogen auf die Summe aller Bestandteile der photopolymerisierbaren reliefbildenden Schicht R, mindestens eines Photopolymerisationsinitiators, der mit den Bestandteilen der reliefbildenden Schicht R verträglich und in dieser Schicht in dem Mass dispergierbar sein soll, welches zur Auslösung der gewünschten Polymerisation oder Vernetzung unter dem Einfluss von aktinischer Strahlung notwendig ist. Als Photopolymerisationsinitiatoren, die allein oder in Mischung miteinander eingesetzt werden können, seien beispielhaft genannt: Acyloine und deren Derivate, wie Benzoin, Benzoinalkylether, z.B. Benzoinmethylether, Benzoinisopropylether, α-Methylolbenzoin und dessen Ether wie z.B. α-Methylolbenzoinmethylether, oder α-Methylbenzoin und α-Methylbenzoinethylether; vicinale Diketone, und deren Derivate, wie z.B. Benzil, Benzilketale wie Benzildimethylketal, Benzilmethylethylketal, Benzilmethylbenzylketal, Benzilethylenglykolketal; unsubstituierte oder substituierte mehrkernige Chinone, wie 9,10-Anthrachinon und Benzanthrachinon; sowie insbesondere Acylphosphinoxid-Verbindungen des Typs wie sie z.B. in der DE-A 2 909 992 und der DE-A 3 114 341 für den Einsatz in photopolymerisierbaren Mischungen beschrieben sind. Bevorzugte Vertreter von Initiatoren aus der Klasse der Acylphosphinoxide sind 2,6-Dimethoxy-benzoyl-diphenylphosphinoxid; 2,4,6-Trimethylbenzoylphenylphosphinsäureethylester und 2,4,6-Trimethylbenzoyl-phenylphosphinsäure-Natrium-Salz. Die Photopolymerisationsinitiatoren können auch in Verbindung mit anderen Koinitiatoren und/oder Aktivatoren, wie sie in der einschlägigen Literatur hinreichend beschrieben sind, verwendet werden.

Oft ist es von Vorteil, wenn die photopolymerisierbare reliefbildende Schicht R neben den genannten Bestandteilen andere übliche Zusatz- und/oder Hilfsstoffe in üblichen Mengen enthält. Hierzu gehören insbesondere thermische Polymerisationsinhibitoren (z.B. Hydrochinon, Hydrochinonderivate, Nitrophenole oder Salze des N-Nitrosocyclohexylhydroxylamins), Farbstoffe und/oder Pigmente, Extender, Weichmacher, Streckmittel etc. Durch geeignete Auswahl von Art und Menge dieser Zusatz- und/oder Hilfsstoffe können die Eigenschaften der photopolymerisierbaren reliefbildenden Schicht R bzw. der daraus hergestellten Druck- oder Reliefformen den jeweiligen speziellen Anwendungszwecken und Anforderungen angepasst werden. Die Zusatz- und/oder Hilfsstoffe werden in an sich bekannten und üblichen Mengen eingesetzt; ihr Anteil soll jedoch etwa 50 Gew.%, vorzugsweise etwa 30 Gew.%, bezogen auf alle Bestandteile der photopolymerisierbaren reliefbildenden Schicht R, nicht übersteigen.

Die photopolymerisierbare reliefbildende Schicht R kann auf der Trägerschicht T direkt aufgebracht sein; es kann jedoch in Abhängigkeit von den eingesetzten Materialien zweckmässig und notwendig sein, die photopolymerisierbare reliefbildende Schicht R auf der Trägerschicht T mittels einer Haftschicht, die im allgemeinen von etwa 0,5 bis 40 μm dick ist, fest zu verankern. Als Haftschichten können handelsübliche Ein- oder Zweikomponentenkleber verwendet werden, deren Art sich nach dem Schichtträgermaterial und dem aufgebrachten Material der reliefbildenden Schicht richtet. Als besonders vorteilhaft haben sich Haftschichten erwiesen, wie sie in der DE-A 3 015 419 für lichtempfindliche Aufzeichnungs-

materialien der in Rede stehenden Art beschrieben sind.

Ebenso kann es vorteilhaft sein, auf die photopolymerisierbare reliefbildende Schicht R noch eine Deckschicht D aufzubringen, wobei eine solche Deckschicht D üblicherweise etwa 0,1 bis 10 µm dick ist. Solche Deckschichten D, die bei der Entwicklung des belichteten Aufzeichnungsmaterials mit abgewaschen werden und daher in Wasser löslich sein sollen, bestehen vorteilhafterweise aus einem Polyvinylalkohol mit einem Verseifungsgrad von mindestens 95 Mol.% und einer Viskosität von 2 bis 8 mPas (gemessen als 4 gew.%ige wässrige Lösung bei 20°C). Die Herstellung von lichtempfindlichen Aufzeichnungsmaterialien der in Rede stehenden Art mit Polyvinylalkohol-Deckschichten ist beispielsweise in der DE-A 3 128 950 beschrieben.

Die Herstellung der erfindungsgemässen lichtempfindlichen Aufzeichnungsmaterialien erfolgt in an sich bekannter Weise durch Herstellen und Verbinden der einzelnen Schichten. Beispielsweise kann die photopolymerisierbare reliefbildende Schicht R durch Giessen aus Lösungen von Gemischen der diese Schicht bildenden Bestandteile auf die Trägerschicht T hergestellt werden. Ebenso können derartige Schichten durch Pressen, Extrudieren oder Kalandrieren hergestellt und dann mit der Trägerschicht T in geeigneter Weise verbunden werden. Die photopolymerisierbare reliefbildende Schicht R der erfindungsgemässen lichtempfindlichen Aufzeichnungsmaterialien hat dabei im allgemeinen eine Schichtstärke von 10 µm bis 7 mm, insbesondere von 300 µm bis 1 mm. Bezüglich weiterer Einzelheiten zur Herstellung der lichtempfindlichen Aufzeichnungsmaterialien wird auf den dem Fachmann bekannten Stand der Technik verwiesen, wie z.B. auf die zu Beginn dieser Anmeldung zitierten Patentschriften.

Die lichtempfindlichen Aufzeichnungsmaterialien der Erfindung eignen sich insbesondere zur Herstellung von Druck- und Reliefformen durch bildmässiges Belichten der photopolymerisierbaren reliefbildenden Schicht R und anschliessendes Entfernen, insbesondere Auswaschen der unbelichteten, unvernetzten Schichtanteile mit Wasser in an sich bekannter Weise. Für die Belichtung, die in Form einer Flach- oder Rundbelichtung erfolgen kann, eignen sich die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, Metallhalogenid-dotierte Lampen, Kohlebogenlampen etc. Die emittierte Wellenlänge soll im allgemeinen zwischen 230 und 450 nm, bevorzugt zwischen 300 und 420 nm liegen und auf die Eigenabsorption des in der photopolymerisierbaren reliefbildenden Schicht R enthaltenen Photoinitiators abgestimmt sein. Wegen der grossen, stark verbesserten Wasserbeständigkeit der belichteten, photovernetzten Reliefschicht besitzen die erfindungsgemässen Aufzeichnungsmaterialien einen grösseren Spielraum beim Auswaschen und Entwickeln mit Wasser als die bisher üblichen Platten der in Rede stehenden Art, d.h., die Auswaschzeit kann verlängert und die Auswaschbedingungen können verschärft werden, ohne dass dies zu einer Beeinträchtigung der Druck- oder Reliefformen führt. Im Gegenteil lassen sich hierdurch schärfere Reliefstrukturen erhalten. Nach dem Auswaschen werden die resultierenden Druck- oder Reliefformen in üblicher Weise, gegebenenfalls bei Temperaturen bis zu 120°C, getrocknet. In manchen Fällen ist es zweckmässig, die erhaltenen Druck- und Reliefformen anschliessend nochmal vollflächig mit aktinischem Licht nachzubelichten, um die Festigkeit der Formen bzw. Druckplatten zu erhöhen.

Die mittels der erfindungsgemässen lichtempfindlichen Aufzeichnungsmaterialien hergestellten Druck- und Reliefformen besitzen eine ausserordentlich hohe Wasserbeständigkeit und eignen sich daher mit besonderem Vorteil für alle Anwendungszwecke, wo diese Eigenschaft von Bedeutung ist. Mit besonderem Vorteil lassen sich beispielsweise mit den erfindungsgemässen lichtempfindlichen Aufzeichnungsmaterialien Prägeformen und Druckplatten herstellen. Derartige Reliefformen besitzen auch in feuchtwarmem Klima eine hohe Lagerbeständigkeit und hohe Wiederverwendbarkeit. Des weiteren zeichnen sie sich durch eine besonders glatte Oberfläche aus.

Die Erfindung wird durch die nachfolgenden Beispiele näher erläutert. Die in den Beispielen genannten Teile und Prozente beziehen sich, soweit nicht anders angegeben, auf das Gewicht. Volumenteile verhalten sich zu Teilen wie Liter zu Kilogramm. Die Molekulargewichte der Polyvinylalkohole wurden bestimmt über die Viskositäten gemessen als 4 gew.%ige wässrige Lösung bei 20°C in einem Höppler-Viskosimeter.

Beispiel 1

1.1 40 Teile eines teilverseiften Polyvinylacetats (Verseifungsgrad 80 Mol.%, durchschnittliches Molekulargewicht 60 000) werden in 60 Teilen Aceton aufgeschlämmt und mit 10 Teilen Methacrylsäureanhydrid versetzt. Das inhomogene Gemisch wird ca. 40 Stunden bei 60°C gerührt. Danach wird über eine Nutsche filtriert. Das erhaltene Polyvinylalkohol-Derivat enthält 2,5% gebundene Methacrylolyl-Gruppen.

1.2 Es wird eine Lösung aus 50 Teilen Wasser, 10 Teilen des gemäss 1.1 hergestellten Polyvinylalkohol-Methacrylsäureanhydrid-Umsetzungsproduktes, 40 Teilen eines teilverseiften Polyvinylacetats (Verseifungsgrad 80 Mol.%, mittleres Molekulargewicht 30 000), 40 Teilen β-Hydroxyethylmethacrylat, 6,0 Teilen Tetraethylenglykoldimethacrylat, 1,5 Teilen Benzildimethylketal und 0,2 Teilen 2,6-Di-tert.-butyl-p-kresol hergestellt. Hieraus wird auf einem mit einem Polyurethan-Haftlack versehenen Stahlblech (Trägerschicht T) eine ca. 2 mm dicke Schicht R geformt und getrocknet.

1.3 Das gemäss 1.2 hergestellte Aufzeichnungsmaterial wird in an sich bekannter Weise zu einer Reliefdruckform verarbeitet, in dem die Schicht R durch Bestrahlung mit aktinischem Licht bildmässig belichtet wird, die nicht belichteten Anteile der Schicht R mit Wasser ausgewaschen werden und die erhaltene Druckform danach getrocknet und nachbelichtet wird. Die resultierenden Druckformen zeigen eine exakte Bildwiedergabe und ausgezeichnete Druckergebnisse selbst nach mehrwöchiger Lagerung bei 25°C und einer relativen Feuchtigkeit von 80%.

Vergleichsversuch A

Es wird wie in Beispiel 1 gearbeitet, anstelle des gemäss 1.1 in heterogener Phase hergestellten Polyvinylalkohol-Derivats werden diesmal jedoch für die Herstellung des Aufzeichnungsmaterials 10 Teile eines Polyvinylalkohol-Derivats eingesetzt, welches wie folgt hergestellt worden war:

20 Teile eines teilverseiften Polyvinylacetats (Verseifungsgrad: 80 Mol.%, mittleres Molekulargewicht 30 000) werden in 80 Teilen Dimethylsulfoxid gelöst und mit 5 Teilen Methacrylsäureanhydrid versetzt. Nach 10 Stunden Reaktionszeit bei 60°C wird das Umsetzungsprodukt durch Eingiessen der Reaktionslösung in Methylenchlorid ausgefällt und abfiltriert.

Mit dem so erhaltenen Polyvinylalkohol-Derivat erhält man Aufzeichnungsmaterialien mit unbefriedigenden Belichtungseigenschaften. Insbesondere feine Reliefelemente sind schwach ausgebildet; negative Bildelemente werden zu flach wiedergegeben.

Beispiel 2

2.1 50 Teile eines teilverseiften Polyvinylacetats (Verseifungsgrad 88 Mol.%, mittleres Molekulargewicht 30 000) werden in 40 Teilen Methylenchlorid aufgeschlämmt und dann mit 60 Teilen Methacrylsäureanhydrid versetzt. Das inhomogene Reaktionsgemisch wird 20 Stunden bei 60°C gerührt, danach das Umsetzungsprodukt abgetrennt und getrocknet. Das erhaltene Polyvinylalkohol-Derivat enthält 15% an gebundenen Methacryloyl-Gruppen.

2.2 Es wird eine Lösung aus 50 Teilen Wasser, 20 Teilen des gemäss 2.1 hergestellten Polyvinylalkohol-Derivats, 15 Teilen eines teilverseiften Polyvinylacetats (Verseifungsgrad 80 Mol.%, mittleres Molekulargewicht 30 000), 15 Teilen eines weiteren teilverseiften Polyvinylacetats (Verseifungsgrad 88 Mol.%, mittleres Molekulargewicht 25 000), 35 Teilen β-Hydroxyethylmethacrylat, 8 Teilen Butandiol-1,4-dimethacrylat, 1,5 Teilen Benzildimethylketal, 0,15 Teilen 2,6-Di-tert.-butyl-p-kresol und 0,05 Teilen N-Nitroso-cyclohexylhydroxylamin hergestellt und damit entsprechend Beispiel 1.2 ein lichtempfindliches Aufzeichnungsmaterial erzeugt.

2.3 Aus diesem Aufzeichnungsmaterial wird durch bildmässiges Belichten mit aktinischem Licht, Auswaschen der unbelichteten Bestandteile der Schicht R mit Wasser sowie Trocknen eine Reliefform mit ausserordentlicher Wasserbeständigkeit hergestellt, die sich mit grossem Vorteil als Prägeform verwenden lässt.

Vergleichsversuch B

Es wird wie in Beispiel 2.2 gearbeitet, jedoch auf den Einsatz des gemäss 2.1 hergestellten Polyvinylalkohol-Derivats verzichtet; statt dessen werden weitere 20 Teile des teilverseiften Polyvinylacetats (Verseifungsgrad 80 Mol.%, mittleres Molekulargewicht 30 000) eingesetzt. Eine analog Beispiel 2.3 hergestellte Reliefform besitzt eine leichter deformierbare Reliefstruktur. Die für die Verwendung als Prägeform ungünstigen mechanischen Eigenschaften werden durch Lagerung in feuchtem Klima weiter verschlechtert.

Beispiel 3

3.1 20 Teile eines teilverseiften Polyvinylacetats (Verseifungsgrad 88 Mol.%, mittleres Molekulargewicht 60 000) werden in 30 Teilen Aceton aufgeschlämmt und mit 10 Teilen Methacrylsäureanhydrid versetzt. Das inhomogene Reaktionsgemisch wird ca. 40 Stunden bei 60°C gerührt, wonach ein Polyvinylalkohol-Derivat isoliert wird, das 10% gebundene Methacryloyl-Gruppen eingebaut enthält.

3.2 Es wird eine Lösung aus 50 Teilen Wasser, 50 Teilen des gemäss 3.1 hergestellten Polyvinylalkohol-Derivats, 40 Teilen β-Hydroxyethylmethacrylat, 4 Teilen Trimethylolpropantriacrylat, 1,5 Teilen Benzildimethylketal und 0,5 Teilen 2,6-Ditert.-butyl-p-kresol hergestellt. Aus dieser Lösung wird auf eine mit einer Haftgrundierung versehene Polyesterfolie eine Schicht R gegossen und getrocknet.

3.3 Das so erhaltene lichtempfindliche Aufzeichnungsmaterial wird vollflächig mit aktinischem Licht belichtet und danach in Stücke von 2 cm×2 cm geschnitten. Diese Stücke werden für ca. 2 Stunden bei 90°C in Wasser extrahiert. Der Gewichtsverlust nach der Extraktion beträgt 8%; die belichteten Proben sind nach der Extraktion noch völlig intakt und gebrauchsfähig.

3.4 Das gemäss 3.2 hergestellte lichtempfindliche Aufzeichnungsmaterial wird mit aktinischem Licht bildmässig belichtet, mit Wasser entwickelt und getrocknet. Man erhält eine Druckform mit scharfen Reliefstrukturen auch bei feinen Linien, hoher Lagerstabilität und Wiederverwendbarkeit.

Vergleichsversuch C

Es wird wie in Beispiel 3 gearbeitet, jedoch anstelle des Polyvinylalkohol-Methacrylsäureanhydrid-Umsetzungsproduktes wird diesmal das nicht umgesetzte, teilverseifte Polyvinylacetat (Verseifungsgrad 88 Mol.%, mittleres Molekulargewicht 60 000) eingesetzt. Die gemäss Beispiel 3 hergestellten und belichteten Proben zeigen bei der Extraktion mit Wasser einen Gewichtsverlust von 50%; die Probenstücke sind danach stark angegriffen und nicht mehr zu gebrauchen. Die bei bildmässiger Belichtung erhaltene Druckform besitzt deutlich schlechtere anwendungstechnische Eigenschaften.

**Patentansprüche**

1. Zur Herstellung von Druck- und Reliefformen geeignetes lichtempfindliches Aufzeichnungsmaterial mit
(a) einer dimensionsstabilen Trägerschicht T und
(b) einer damit direkt oder indirekt haftfest verbundenen photopolymerisierbaren, wasserentwickelbaren reliefbildenden Schicht R mit einer Schichtstärke von 300 µm bis 7 mm aus einer Mischung von
(b1) einem ein polymerisierbares Polyvinylalkohol-Derivat enthaltenden polymeren Bindemittel,
(b2) mindestens einer mit dem polymeren Bindemittel verträglichen, ethylenisch ungesättigten, photopolymerisierbaren niedermolekularen Verbindung,
(b3) mindestens einem Photopolymerisationsinitiator sowie gegebenenfalls
(b4) weiteren üblichen Zusatz- und/oder Hilfsstoffen, dadurch gekennzeichnet, dass die photopolymerisierbare reliefbildende Schicht R als polymeres Bindemittel mindestens 1 Gew.%, bezogen auf das gesamte polymere Bindemittel (b1), eines Polyvinylalkohol-Derivats enthält, welches 1 bis 30 Gew.%, bezogen auf das Polyvinylalkohol-Derivat, an radikalisch polymerisierbare Gruppen enthaltenden Acylresten eingebaut enthält und erhalten worden ist durch Umsetzung von Polyvinylalkohol mit einem radikalisch polymerisierbare Gruppen enthaltenden Acylierungsmittel in heterogener Phase in einem aprotischen Dispergiermittel mit einem 2- bis 5-molar-fachen Überschuss an Acylierungsmittel, bezogen auf den Gehalt an Acylgruppen in dem Polyvinylalkohol-Derivat.

2. Lichtempfindliches Aufzeichnungsmaterial gemäss Anspruch 1, dadurch gekennzeichnet, dass das in der photopolymerisierbaren reliefbildenden Schicht R als polymeres Bindemittel enthaltene Polyvinylalkohol-Derivat erhalten worden ist durch Umsetzung von Polyvinylalkohol mit Acrylsäureanhydrid und/oder Methacrylsäureanhydrid als Acylierungsmittel.

3. Lichtempfindliches Aufzeichnungsmaterial gemäss Ansprüchen 1 und 2, dadurch gekennzeichnet, dass die photopolymerisierbare reliefbildende Schicht R als polymeres Bindemittel (b1) 10 bis 40 Gew.%, bezogen auf das gesamte polymere Bindemittel (b1), des Polyvinylalkohol-Derivats mit eingebauten radikalisch polymerisierbare Gruppen enthaltenden Acylresten sowie 90 bis 60 Gew.%, bezogen auf das gesamte polymere Bindemittel (b1), an weiteren mit dem Polyvinylalkohol-Derivat weitgehend verträglichen, wasserlöslichen oder wasserdispergierbaren Polymerbindemitteln enthält.

4. Verfahren zur Herstellung von Druck- und Reliefformen mittels eines lichtempfindlichen Aufzeichnungsmaterials mit einer Trägerschicht T und einer damit haftfest verbundenen wasserentwickelbaren photopolymerisierbaren reliefbildenden Schicht R durch bildmässiges Belichten der photopolymerisierbaren reliefbildenden Schicht R mit aktinischem Licht, Auswaschen der unbelichteten, unvernetzten Bereiche der photopolymerisierbaren reliefbildenden Schicht R mit Wasser und anschliessendem Trocknen sowie gegebenenfalls Nachbelichten der erhaltenen Reliefform, dadurch gekennzeichnet, dass ein lichtempfindliches Aufzeichnungsmaterial gemäss einem der Ansprüche 1 bis 3 eingesetzt wird.

**Claims**

1. A photosensitive recording material which is suitable for the production of printing plates and relief plates and comprises
(a) a dimensionally stable base B and
(b) a photopolymerizable, relief-forming layer R which is firmly bonded to the base directly or indirectly, has a thickness of from 300 µm to 7 mm, can be developed with water and consists of a mixture of
($b_1$) a polymeric binder containing a polymerizable polyvinylalcohol derivative,
($b_2$) at least one ethylenically unsaturated, photopolymerizable, low molecular weight compound which is compatible with the polymeric binder, and
($b_3$) at least one photopolymerization initiator, with or without
($b_4$) further conventional additives and/or assistants, wherein the photopolymerizable relief-forming layer R contains, as the polymeric binder, not less than 1% by weight, based on the total polymeric binder ($b_1$), of a polyvinylalcohol derivative which contains from 1 to 30% by weight, based on the polyvinylalcohol derivative, of acyl radicals containing groups which can be polymerized by free radicals, and has been obtained by reacting polyvinylalcohol with an acylating agent containing groups which can be polymerized by free radicals, the reaction being carried out in the heterogeneous phase, in an aprotic dispersant, using a two- to fivefold molar excess of acylating agent, based on the content of acyl groups in the polyvinylalcohol derivative.

2. A photosensitive recording material as claimed in claim 1, wherein the polyvinylalcohol derivative present as the polymeric binder in the photopolymerizable relief-forming layer R has been obtained by reacting polyvinylalcohol with acrylic anhydride and/or methacrylic anhydride as the acylating agent.

3. A photosensitive recording material as claimed in claims 1 and 2, wherein the photopolymerizable relief-forming layer R contains, as the polymeric binder ($b_1$), from 10 to 40% by weight, based on the total polymeric binder ($b_1$), of the polyvinylalcohol derivative possessing acyl radicals containing groups which can be polymerized by free radicals, and from 90 to 60% by weight, based on the total polymeric binder ($b_1$), of further water-soluble or water-dispersible poly-

meric binders which are substantially compatible with the polyvinylalcohol derivative.

4. A process for the production of a printing plate or a relief plate using a photosensitive recording material comprising a base B and a photopolymerizable relief-forming layer R which is firmly bonded to the base and can be developed with water, by imagewise exposure of the relief-forming layer R to actinic light, washing out the unexposed, non-crosslinked areas of the layer R with water, subsequent drying and optional afterexposure of the resulting relief plate, wherein a photosensitive recording material as claimed in any of claims 1 to 3 is employed.

**Revendications**

1. Matériau d'enregistrement photosensible convenant pour la fabrication de formes à relief et de plaques d'impression, comprenant:
(a) une couche support T dimensionnellement stable et
(b) une couche R photopolymérisable et développable à l'eau, formant le relief, adhérant directement ou indirectement à la couche T, possédant une épaisseur de 300 µm à 7 mm et composée d'un mélange de
(b1) un liant polymère, contenant un dérivé d'alcool polyvinylique polymérisable,
(b2) au moins un composé à insaturation éthylénique photopolymérisable à bas poids moléculaire, compatible avec le liant polymère,
(b3) au moins un amorceur de la photopolymérisation et
(b4) d'autres additifs et(ou) adjuvants usuels éventuels, caractérisé en ce que la couche photopolymérisable R formant le relief contient comme liant polymère au moins 1% du poids total de ce liant polymère (b1) d'un dérivé d'alcool polyvinylique, dans lequel sont copolymérisés entre 1 et 30% de son poids de groupes acyle à groupes polymérisables par des radicaux libres et qui a été obtenu par réaction en phase hétérogène, dans un agent de dispersion aprotique, d'alcool polyvinylique et d'un agent d'acylation contenant des groupes polymérisables par des radicaux libres, l'agent d'acylation étant mis en œuvre en un excès 2 à 5 molaire par rapport à la teneur en groupes acyle du dérivé d'alcool polyvinylique.

2. Matériau d'enregistrement photosensible selon la revendication 1, caractérisé en ce que le dérivé d'alcool polyvinylique, contenu dans la couche photopolymérisable R formant le relief comme liant polymère, a été obtenu par la réaction de l'alcool polyvinylique avec l'anhydride de l'acide acrylique et(ou) l'anhydride de l'acide méthacrylique comme agent(s) d'acylation.

3. Matériau d'enregistrement photosensible selon les revendications 1 et 2, caractérisé en ce que la couche photopolymérisable R formant le relief contient comme liant polymère (b1) entre 10 et 40% du poids total de ce liant polymère de dérivé de l'alcool polyvinylique, dans lequel sont copolymérisés des groupes acyle à groupes polymérisables par des radicaux libres, ainsi que 90 à 60% du poids total de ce liant polymère (b1) d'autres liants hydrosolubles ou dispersables dans l'eau et largement compatibles avec le dérivé de l'alcool polyvinylique.

4. Procédé de fabrication de formes à relief et de plaques d'impression à l'aide d'un matériau d'enregistrement photosensible, comprenant une couche support T et une couche R photopolymérisable et développable à l'eau, formant le relief, adhérant à la couche T, par exposition de la couche photopolymérisable R, formant le relief, suivant une image à de la lumière actinique, élimination par un lavage à l'eau des régions non exposées non réticulées de la couche photopolymérisable R formant le relief, séchage et éventuellement post-exposition de la forme à relief obtenue, caractérisé en ce que l'on utilise un matériau d'enregistrement photosensible selon l'une des revendications 1 à 3.